# FASCICULE DE BREVET EUROPEEN

(11) **EP 2 989 732 B1**
(45) Date de publication et mention de la délivrance du brevet: **13.06.2018**
(21) Numéro de dépôt: 14726698.5
(22) Date de dépôt: 25.04.2014
(51) Int. Cl.: H04B 10/25, H04B 10/40, H04B 10/80

(54) **BANC DE TESTS CEM COMPRENANT UN ÉQUIPEMENT SOUS TESTS DESTINE A ÊTRE EMBARQUE DANS UN AÉRONEF**
EMV-PRÜFSTAND MIT EINEM PRÜFLING ZUR BELADUNG AN BORD EINES FLUGZEUGS
EMC TEST BENCH COMPRISING AN ITEM OF EQUIPMENT UNDER TEST WHICH IS INTENDED TO BE LOADED ON BOARD AN AIRCRAFT

(30) Priorité: 26.04.2013 FR 1353850
(43) Date de publication de la demande: 02.03.2016
(73) Titulaire: Snecma, 75015 Paris (FR)
(72) Inventeur: SALVATGE, Rémy, F-77000 Melun (FR); LAIR, Cyril, F-77340 Pontault-Combault (FR)
(74) Mandataire: Cabinet Camus Lebkiri
(86) Numéro de dépôt international: PCT/FR2014/051004
(87) Numéro de publication internationale: WO 2014/174224

(56) Documents cités:
- US-A1- 2007 014 577
- US-A1- 2011 243 566
- MACDIARMID I P: "Proposed developments in EMC design and testing as a result of the use of modular avionics", 19961111, 11 novembre 1996 (1996-11-11), pages 7/1-7/7, XP006509377,
- HE T ET AL: "Investigation of test methods for DO-160 qualification tests", 2003 IEEE INTERNATIONAL SYMPOSIUM ON ELECTROMAGNETIC COMPATIBILITY. EMC. SYMPOSIUM RECORD. BOSTON, MA, AUG. 18 - 22, 2003; [INTERNATIONL SYMPOSIUM ON ELECTROMAGNETIC COMPATIBILITY], NEW YORK, NY : IEEE, US, vol. 1, 18 août 2003 (2003-08-18), pages 120-123, XP010660718, DOI: 10.1109/ISEMC.2003.1236575 ISBN: 978-0-7803-7835-3
- PEREZ-MATO J ET AL: "Experimental approach to an optical wireless interface for an avionics data bus", DIGITAL AVIONICS SYSTEMS CONFERENCE (DASC), 2012 IEEE/AIAA 31ST, IEEE, 14 octobre 2012 (2012-10-14), pages 7E4-1, XP032279793, DOI: 10.1109/DASC.2012.6382427 ISBN: 978-1-4673-1699-6
- MARK BERANEK ET AL: "Military and aerospace standards for digital avionics fiber optic systems", DIGITAL AVIONICS SYSTEMS CONFERENCE (DASC), 2011 IEEE/AIAA 30TH, IEEE, 16 octobre 2011 (2011-10-16), pages 7B2-1, XP032069415, DOI: 10.1109/DASC.2011.6096117 ISBN: 978-1-61284-797-9

## Description

### DOMAINE

La présente invention se rapporte au domaine technique des systèmes permettant d'assurer une immunité électrique de bancs de tests CEM tout en préservant la représentativité des tests conduits. Plus particulièrement, le domaine de l'invention concerne les dispositifs d'isolation des liaisons notamment des interfaces ARINC dans de tels bancs de tests. Enfin, le domaine concerne les systèmes permettant d'assurer une protection des bancs de tests vis-à-vis des perturbations et détériorations causées lors de tests CEM de tenue de Foudre, dits d' « injection foudre ».

### ETAT DE L'ART

Il existe des bancs de tests permettant de réaliser des tests CEM notamment des essais dits « Foudre » permettant de tester la résistance des composants électroniques à la foudre, tel que celui décrit dans l'article de I. P. MacDiarmid intitulé "Proposed developments in E.M.C. design and tesing as a result of the use of modular avionic" publié en 1996 par l'IEE. Les bancs de tests CEM comprennent généralement une baie de contrôle/commande qui permet de piloter les tests et traiter des données pour en effectuer des mesures et contrôler certains indicateurs de fonctionnement. Il y a généralement un système électronique à tester et un simulateur d'interfaces physique permettant de reproduire une configuration opérationnelle entre le système sous tests et son environnement.

Par ailleurs, les liaisons ARINC sont très répandues dans les équipements électroniques destinés à être embarqués dans les aéronefs. Elles définissent notamment des standards de communications qui sont implémentés pour le contrôle d'équipements et assurer les transferts de données entre lesdits équipements.

Un des inconvénients des solutions existantes est qu'elles ne permettent pas d'assurer l'immunité de la baie de contrôle/commande à une injection foudre sur des équipements. En effet, l'ARINC 429 qui permet d'établir la liaison entre la baie de contrôle/ commande et l'équipement testé nécessite une interface électrique et un protocole pour véhiculer des données numériques qui sont susceptibles d'être perturbées par un tel test d'injection foudre.

Il est alors difficile d'assurer l'isolation des liaisons aboutissant à la baie de contrôle/commande. Malgré les protections des interfaces qui peuvent être mises en place, les liaisons sont susceptibles d'être perturbées par les effets d'injections foudre et peuvent conduire à une détérioration ou à des perturbations de la baie de contrôle/commande.

Un des problèmes des protections intermédiaires anti-foudre, qui peuvent être mises en place en amont de la baie contrôle/commande, est que ces dernières peuvent influencer les mesures.

En effet, les protections et filtrages supplémentaires peuvent être ajoutés pour s'assurer que la baie de contrôle/commande ne soit pas perturbée. Mais ils/elles ne permettent pas d'obtenir une représentativité du contexte opérationnel vis-à-vis de la réalité de l'aéronef.

Il est donc difficile d'assurer d'une part l'immunité et l'intégrité de la baie de contrôle/commande et d'autre part d'assurer une bonne représentativité des tests et des interfaces électriques reflétant un contexte opérationnel.

Un déport de la baie de contrôle / commande peut être effectué, en revanche cette action ne permet pas de préserver les cartes d'acquisition des lignes ARINC, par exemple, des surtensions générées par les tests d'injections foudre.

### RESUME DE L'INVENTION

L'invention permet de résoudre les inconvénients précités.

Un objet de l'invention concerne un dispositif convertisseur d'un signal électrique ARINC en un signal TTL optique comprenant un connecteur d'entrée apte à recevoir un premier signal ARINC et à le délivrer dans une première voie, caractérisé en ce que la première voie comprend :
- un premier convertisseur du premier signal ARINC reçu en un signal premier TTL électrique ;
- un second convertisseur du premier signal TTL électrique précédemment converti en un premier signal TTL optique ;
- un composant émetteur du premier signal TTL optique précédemment converti vers un connecteur optique connecté à une fibre optique permettant d'acheminer ledit premier signal TTL optique vers un équipement de contrôle.

Avantageusement, le connecteur optique est apte à recevoir un second signal TTL optique et à le délivrer dans une seconde voie du dispositif convertisseur, ce dernier comprenant :
- un composant d'acquisition du second signal TTL optique provenant du connecteur optique;
- un troisième convertisseur du second signal TTL optique reçu en un second signal TTL électrique ;
- un quatrième convertisseur du second signal TTL électrique précédemment converti en un second signal ARINC.

Avantageusement, le dispositif convertisseur comprend en outre une alimentation délivrant à la première voie et à la seconde voie une alimentation de tension continue.

Un avantage d'un dispositif convertisseur comprenant deux voies est qu'il permet d'être utilisé pour la conversion de signaux électriques en signaux optiques et réciproquement. Un avantage est de permettre de construire une liaison immune lorsque deux dispositifs convertisseurs sont placés en regard au niveau des entrées/ sorties de deux équipements électroniques.

Un autre objet de l'invention concerne un système de conversion de signaux, pour la protection d'une baie de contrôle, comprenant :
- un premier dispositif convertisseur selon l'invention ;
- un second dispositif convertisseur selon invention ;
- au moins une fibre optique permettant d'acheminer des signaux optiques du premier au second convertisseur et/ou réciproquement.

Le système de conversion de signaux est alors d'une part connecté à une baie de contrôle / commande et d'autre part connecté à un dispositif électronique comprenant une carte d'acquisition et/ou de génération de signaux ARINC.

Un autre objet de l'invention concerne un banc de tests CEM, comprenant :
- un équipement sous tests destiné à être embarqué dans un aéronef, le dit équipement étant soumis à des tests CEM et délivrant des interfaces électriques ARINC en entrées et en sortie ;
- un dispositif d'interfaces électriques représentatif d'un équipement anti-foudre et comprenant une carte d'acquisition et/ou de génération de signaux ARINC connecté aux entrées et sorties ARINC de l'équipement sous tests;
- une baie de contrôle / commande pour l'analyse de signaux de contrôle provenant du dispositif d'interfaces électriques comprenant une carte d'acquisition et/ou de génération de signaux ARINC ;
- un système de conversion de signaux pour la protection de la baie de contrôle/ commande connecté entre ladite baie de contrôle / commande et le dispositif d'interfaces électriques.

Avantageusement le dispositif d'interfaces électriques comprend :
- une protection foudre permettant de limiter la tension de mode commun maximale de 20VDC ;
- une impédance d'entrée adaptée au premier dispositif convertisseur.

Avantageusement des commandes électriques générées à partir de la baie de contrôle / commande sont convertis par le second dispositif convertisseur en signaux optiques et délivrés au moyen d'une fibre optique au premier dispositif convertisseur délivrant au dispositif d'interfaces électriques des signaux convertis aux formats ARINC électrique.

Avantageusement, l'équipement sous test est un système de régulation.

Vis-à-vis de l'état de la technique, un avantage de la solution de l'invention est d'apporter une immunité du banc vis-à-vis des essais foudre et permet en même temps d'assurer la représentativité de l'interface électrique agressée.

Avantageusement, le premier signal et le second signal ARINC sont des signaux ARINC 429 et les interfaces électriques ARINC de l'équipement sous test sont adaptées à l'émission/réception des signaux ARINC 429.

### BREVE DESCRIPTION DES FIGURES

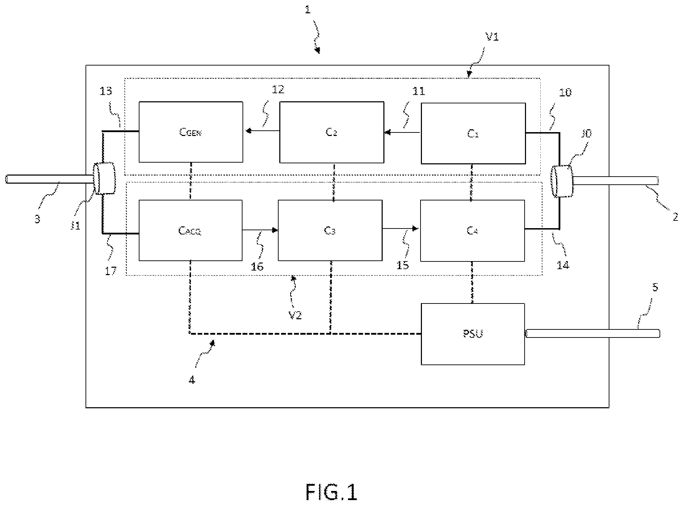

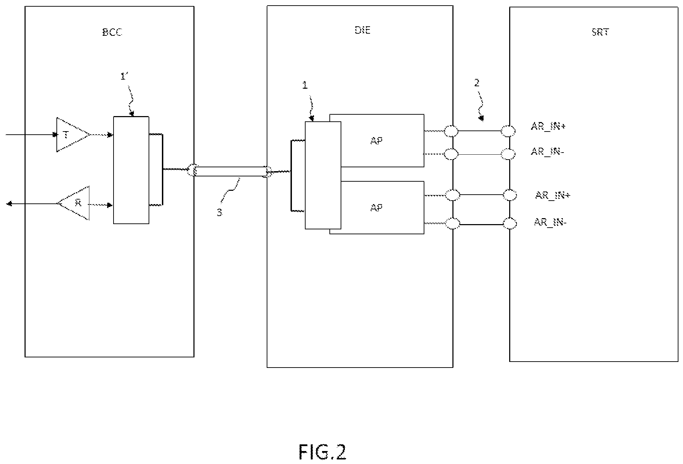

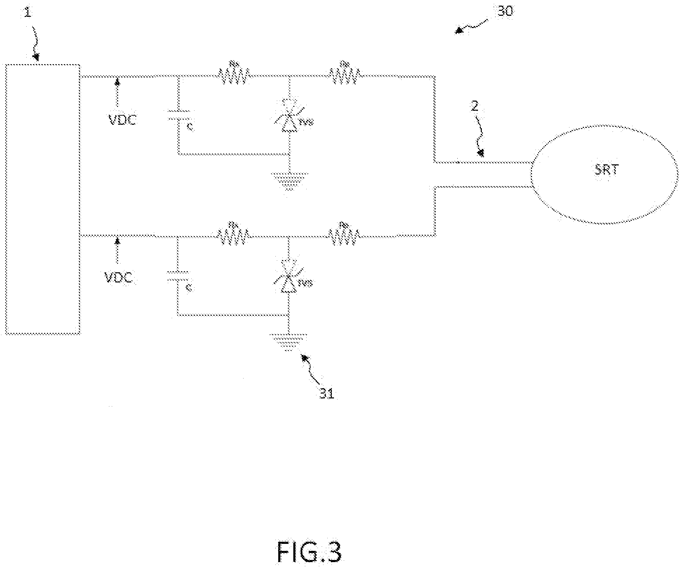

D'autres caractéristiques et avantages de l'invention ressortiront à la lecture de la description détaillée qui suit, en référence aux figures annexées, qui illustrent :
▪ figure 1 : un dispositif convertisseur de signaux ARINC en signaux optiques et réciproquement ;
▪ figure 2 : un système de test CEM d'un équipement sous test comprenant un système de conversion de signaux optique-électrique ;
▪ figure 3 : un circuit électrique assurant une protection anti-foudre de signaux ARINC connecté à dispositif convertisseur de l'invention ;

### DESCRIPTION

On appelle test CEM, un test de compatibilité d'un équipement CEM à un environnement CEM envisagé opérationnellement. Selon les plans de tests, il existe différents type de tests tels que :
- des essais d'endurance et de résistance à un environnement électromagnétique donné définis sur période de temps donné ;
- des essais destructifs qui visent à étudier les limites de fonctionnements d'un équipement à des valeurs aux limites ;
- des essais contextuels qui viennent à reproduire un évènement pouvant survenir opérationnellement tel que la foudre, etc.

L'invention décrite ci-après est notamment appropriée à la protection des moyens de tests tels qu'une baie de contrôle/commande à des essais dits d'injections foudre.

Les baies de contrôle /commande comprennent selon les cas de figures : des cartes d'acquisition de données, un pupitre électrique, une mémoire pour la sauvegarde de données réceptionnées, un PC ou une unité de calculs permettant d'effectuer des opérations sur les données reçues.

La figure 1 représente un mode de réalisation de l'invention dans lequel un convertisseur 1 de signaux ARINC électriques en signaux optiques et réciproquement permet de préserver la baie de contrôle/commande immune des essais dits d'injections foudre. La baie contrôle/commande est notée BCC sur la figure 2.

Le convertisseur 1 comprend deux voies V1, V2 permettant d'assurer respectivement d'une part la conversion des signaux électriques en signaux optiques et d'autre part la conversion des signaux optiques en signaux électriques.

Un toron 2 permet d'acheminer les liaisons ARINC provenant d'un dispositif d'interfaces électriques, noté DIE, connecté à un système sous test, noté SRT. Les signaux ARINC sont ensuite acheminés vers un premier convertisseur C1 via un connecteur J₀. Les signaux sont acheminés au moyen d'une liaison 10 comprenant deux brins. La connexion peut être réalisée par l'intermédiaire d'une paire torsadée blindée composée de deux brins, également appelés lignes. Le transfert des données est réalisé en différentiel entre les deux lignes de la paire.

Les signaux provenant du dispositif d'interfaces électriques ARINC sont transférés selon la norme ARINC 429 et ont une forme trapézoïdale. Le premier convertisseur C1 permet de convertir les signaux ARINC 429 électriques en signaux TTL électriques. Un signal TTL est défini par un premier niveau logique bas entre 0 et 0,5 V et un second niveau logique haut entre 2,4 V et 5 V. Selon les variantes, ces niveaux varient légèrement entre les différentes séries. Le signal TTL électrique a une forme de créneau.

Le signal TTL converti par le premier convertisseur C1 est transmis via une liaison 11 vers un second convertisseur C2.

Le second convertisseur C2 permet de convertir un signal TTL électrique en un signal TTL optique. Le signal optique est alors transmis via une liaison optique 12 vers un composant C_{GEN} permettant de générer sur une fibre optique 13 le signal optique vers la baie contrôle/commande BCC.

Un toron 3 permet d'acheminer les données transitant sur la liaison optique 13 vers la baie contrôle/commande BCC.

La conversion des signaux électriques en signaux optiques permet d'assurer une isolation dite « optique » de la baie de contrôle/ commande BCC.

Le convertisseur 1 comprend une seconde voie V2 permettant de convertir les signaux optiques reçus de la baie de contrôle/ commande BCC et de les transformer en signaux électriques. Les signaux provenant du toron 3 sont acheminés via le connecteur J₁ et via la liaison optique 17 vers une carte d'acquisition C_{ACQ} des signaux optiques. La liaison optique 17 peut être une fibre optique. Ils sont ensuite acheminés via une liaison 16 vers un troisième convertisseur C3 pour convertir les signaux TTL optiques en signaux TTL électriques. Les signaux TTL électriques sont ensuite acheminés via la liaison 15 vers un quatrième convertisseur C4 pour une conversion selon la norme ARINC électrique, notamment en signaux ARINC 429 dans cet exemple. Les signaux ARINC 429 sont acheminés via la liaison 14 en sortie du convertisseur C4 dans un toron 2 pour être traités par le dispositif d'interfaces électriques DIE.

Les signaux qui sont transférés de la baie contrôle/commande vers le dispositif d'interfaces électriques permettent par exemple de piloter le SRT ou d'envoyer des commandes ou des configurations permettant de dérouler une série de tests CEM selon différentes configurations. En outre, le DIE peut être alimenté par la baie contrôle/commande.

Les signaux qui sont transférés du dispositif d'interfaces électriques vers la baie contrôle/commande permettent par exemple de remonter les variations d'états électriques de l'équipement sous test SRT, d'étudier les réponses aux perturbations CEM injectés, de détecter des comportements aux limites dudit équipement sous test afin de certifier un équipement pour sa mise en production opérationnelle.

Les différents composants du convertisseur 1 tels que les convertisseurs C1, C2, C3, C4 et les composants d'acquisitions de signaux, tel que C_{ACQ} et les composants générant les signaux sur les lignes C_{GEN} sont alimentés par une alimentation externe, notée PSU. L'alimentation PSU peut être intégrée au convertisseur 1. L'alimentation PSU permet de délivrer, à partir d'une distribution 4 de liens d'alimentation, des tensions continues aux différents composants du convertisseur 1. Les tensions continues délivrées peuvent être par exemple de 12V ou de 24V.

L'alimentation PSU est elle-même alimentée par une alimentation 220V ou 110V externe via une liaison d'alimentation 5.

La figure 2 représente le banc de tests CEM ainsi que ses interfaces, notamment ARINC et optiques. Il comprend une baie de contrôle /commande BCC, un dispositif d'interfaces électriques DIE et un équipement sous tests CEM noté système SRT. L'équipement sous tests CEM est un système de régulation noté SRT. Le convertisseur 1 précédemment décrit au travers la figure 1 est ici représenté par le bloc 1 de la figure 2.

Le système SRT sous tests CEM est sollicité de sorte à permettre un contrôle de son évolution de fonctionnement par la baie contrôle/commande BCC. Un test d'injection foudre consiste à injecter dans le système SRT de fortes décharges électriques et à étudier l'évolution du comportement électrique du système sous tests.

La baie de contrôle / commande BCC permet :
- l'acquisition et le traitement et les enregistrements des données sous forme de signaux électriques, notamment de ceux qui sont mesurés ou surveillés par le banc de tests ;
- le contrôle de tous les paramètres de réglages du banc de tests CEM.

Le dispositif d'interfaces électriques DIE permet de reproduire fidèlement le contexte opérationnel de sorte à assurer une représentativité des tests CEM, notamment en termes d'interfaces électriques. Il comprend des modules, notés AP désignant « protection avion », permettant d'offrir à l'équipement sous test SRT des interfaces identiques à celles du contexte opérationnel qui correspondent par exemple au module de protection avion du type protection anti-foudre

Le dispositif d'interfaces électriques DIE permet en outre d'implémenter des solutions de protection foudre.

La figure 2 représente la baie de contrôle / commande BCC comprenant un bloc 1'. Le bloc 1' comprend un convertisseur tel que décrit à la figure 1. Le convertisseur 1' est en revanche mis en regard du convertisseur 1 de sorte qu'il convertisse les signaux optiques provenant du toron 3 en signaux électriques. Les signaux TTL optiques sont alors successivement convertis en signaux TTL électriques et en signaux ARINC 429.

L'implémentation de deux convertisseurs optique/électrique entre le dispositif d'interfaces électriques et la baie de contrôle / commande permet d'immuniser la baie de potentielles détériorations et perturbations causées par exemples par la génération de surtensions.

Le baie de contrôle / commande est donc de ce fait protégée des surtensions électriques grâce aux convertisseurs C1 et C2 qui permettent le passage en optique des données du dispositif d'interfaces électrique DIE vers la baie.

La conversion des signaux au format optique évite de propager toute potentielle surtension aux cartes d'acquisitions de la baie de contrôle/commande BCC. Les cartes d'acquisition ARINC de la baie contrôle / commande sont ainsi protégées de détériorations pouvant survenir provoquées par une/des surtension(s) ou de comportements inappropriés tels que par exemple l'arrêt spontané de la baie.

De plus, les fibres optiques sont, par définition, incapables de rayonner et ainsi, par diaphonie, de perturber d'autres signaux électriques acquis par le banc au niveau de la baie de contrôle / commande BCC.

Le type de signal optique : « TTL optique » est un format de signal permettant de retranscrire fidèlement les données transmises tout en assurant une immunité de la baie de contrôle / commande et des cartes d'acquisition.

Afin d'assurer la représentativité électrique de l'interface, le premier étage de conversion optique peut être configurée de sorte à avoir une 'impédance d'entrée équivalente à celle d'un récepteur ARINC et inversement une impédance de sortie pour un transmetteur ARINC.

La mise en place d'une liaison optique permet d'éviter la propagation de perturbations électriques vers la baie de contrôle/commande et assure ainsi une diminution des cas de pannes ou de détérioration des équipements de la baie.

Un des avantages du double étage de conversion de signaux de l'invention est qu'il est adapté à la forme particulière du signal ARINC. Notamment, les montées et descentes du signal doivent être faites en des temps bien précis, le signal a une alternance positive et négative et rend difficile une conversion électrique/optique directe.

Une première conversion du signal ARINC en un signal TTL électrique permet d'assurer une impédance d'entrée équivalente à un récepteur ARINC. Ce signal TTL électrique est ensuite converti en un signal TTL optique par exemple au moyen d'un optocoupleur, également appelé photocoupleur.

En réception, le signal optique est traduit en un signal TTL électrique puis en un signal équivalent ARINC électrique.

Un des avantages du dispositif convertisseur de l'invention est que la conversion des signaux permet d'harmoniser toutes les isolations optiques TTL du banc de tests et de répondre ainsi à une exigence de représentativité du mode opérationnel.

L'isolation optique des signaux transmis permet de connecter des sous-ensembles entre eux sans engendrer des détériorations lors de la mise en oeuvre de tests d'injections foudre. Ainsi le dispositif convertisseur comprenant un premier convertisseur, un toron optique et un second convertisseur peut être utilisé de sorte à s'interposer entre deux équipements ayant des interfaces ARINC.

Ainsi le dispositif convertisseur peut être utilisé en tant qu'isolant électromagnétique des transmissions entre deux équipements.

Les convertisseurs et récepteurs sont ainsi identiques de part et d'autre du dispositif d'interfaces électriques DIE et de la baie de contrôle / commande BCC.

La solution de l'invention permet de limiter le nombre d'équipements différents dans le banc de tests. En outre, les interfaces sont faciles à remplacer en cas de détérioration.

La figure 3 représente un mode de réalisation de l'interface entre un module AP noté 30 du dispositif d'interfaces électriques DIE et le convertisseur 1 de signaux.

La condition de bon fonctionnement de cette solution est de s'assurer que le circuit électronique supporte la tension de mode commun résiduelle après la protection avion. Ceci dépend bien sûr de la protection implémentée 31, et donc de l'avion puisque celle-ci est identique à la protection avion. La tension résiduelle est un transitoire avec un niveau de tension de 11VDC maximum. Cette tension correspond à la tension d'écrêtage de la diode TVS, dont l'acronyme désigne les termes : « Transient Voltage Suppression ». La diode TVS est représentée à la figure 3 dans l'étage 31 correspondant à la fonction de« protection foudre ».

Afin d'avoir une marge de bon fonctionnement, le circuit d'isolation est étudié pour une tension de mode commun maximale de 20VDC.

## Revendications

1. Banc de tests de compatibilité électromagnétique, dit « CEM », comprenant:
• un équipement sous tests, noté "SRT", destiné à être embarqué dans un aéronef, le dit équipement étant soumis à des tests CEM et délivrant des interfaces électriques de type « Aeronautical Radio, Incorporated », noté « ARINC », en entrées et en sortie ;
• un dispositif d'interfaces électriques, noté "DIE", représentatif d'un équipement anti-foudre et comprenant une carte d'acquisition et/ou de génération de signaux ARINC connecté aux entrées et sorties ARINC de l'équipement sous tests ; et
• une baie de contrôle / commande, notée "BCC", pour l'analyse de signaux de contrôle provenant du dispositif d'interfaces électriques comprenant une carte d'acquisition et/ou de génération de signaux ARINC ; **caractérisé en ce qu'**il comprend également
• un système de conversion de signaux pour la protection de la baie de contrôle/ commande adapté à convertir un signal ARINC électrique en un signal optique et réciproquement, ledit système de conversion de signaux étant connecté entre ladite baie de contrôle / commande et le dispositif d'interface électrique.

2. Banc de tests CEM selon la revendication 1, **caractérisé en ce que** le dispositif d'interface électriques comprend :
• une protection foudre (31) permettant de limiter la tension de mode commun maximale de 20VDC ;
• une impédance d'entrée adaptée au premier dispositif convertisseur.

3. Banc de test CEM selon l'une quelconque des revendications 1 à 2, **caractérisé en ce que** le système de conversion de signaux pour la protection d'une baie de contrôle comprend :
• un premier dispositif convertisseur (1) d'un signal électrique ARINC en un signal TTL optique et/ou réciproquement ;
• un second dispositif convertisseur (1') d'un signal électrique ARINC en un signal TTL optique et/ou réciproquement ;
• au moins une fibre optique permettant d'acheminer des signaux optiques du premier au second convertisseur et/ou réciproquement,
ledit système de conversion de signaux étant d'une part connecté à la baie de contrôle / commande et d'autre part à l'équipement sous test ce dernier comprenant une carte d'acquisition et/ou de génération de signaux ARINC.

4. Banc de tests CEM selon la revendication 3, **caractérisé en ce que** :
• le dispositif d'interfaces électriques comprend le premier dispositif convertisseur (1) ;
• la baie de contrôle / commande comprend le second dispositif convertisseur (1'), et
• la fibre optique relie le dispositif d'interfaces électriques à la baie de contrôle / commande par l'intermédiaire des premier et le second dispositifs convertisseurs (1, 1').

5. Banc de test CEM selon l'une quelconque des revendications 3 à 4, **caractérisé en ce que** des commandes électriques générées à partir de la baie de contrôle / commande sont converties par le second dispositif convertisseur (1') en signaux optiques et sont délivrées au moyen d'une fibre optique (17) au premier dispositif convertisseur (1) délivrant au dispositif d'interfaces électriques des signaux convertis (14) aux formats ARINC électrique.

6. Banc de test CEM selon l'une quelconque des revendications 1 à 5, **caractérisé en ce que** l'équipement sous test est un système de régulation.

7. Banc de test CEM selon l'une quelconque des revendications 3 à 6, **caractérisé en ce que** chaque dispositif convertisseur (1, 1') comprend un connecteur d'entrée (J_{O}) apte à recevoir un premier signal ARINC et à le délivrer dans une première voie (V1), ladite première voie (V1) comprenant :
• un premier convertisseur (C1) du premier signal ARINC reçu en un premier signal TTL électrique ;
• un second convertisseur (C2) du premier signal TTL électrique précédemment converti en un premier signal TTL optique ;
• un composant émetteur (C_{GEN}) du premier signal TTL optique précédemment converti vers un connecteur optique (J₁) connecté à une fibre optique (13) permettant d'acheminer ledit premier signal TTL optique vers un équipement de contrôle

8. Banc de test CEM selon l'une quelconque des revendications 3 à 7, **caractérisé en ce que** chaque dispositif convertisseur (1, 1') comprend un connecteur optique (J₁) apte à recevoir un second signal TTL optique (17) et à le délivrer dans une seconde voie (V2) comprenant :
• un composant d'acquisition (C_{ACQ}) du second signal TTL optique provenant du connecteur optique (J₁) ;
• un troisième convertisseur (C3) du second signal TTL optique reçu en un second signal TTL électrique ;
• un quatrième convertisseur (C4) du second signal TTL électrique précédemment converti en un second signal ARINC.

9. Banc de test CEM selon l'une quelconque des revendications 7 à 8 **caractérisé en ce qu'**il comprend en outre une alimentation (PSU) délivrant à la première voie (V1) et à la seconde voie (V2) une alimentation de tension continue.

10. Banc de test CEM selon l'une quelconque des revendications 1 à 9, **caractérisé en ce que** :
- le premier signal et le second signal ARINC sont des signaux ARINC 429 et ;
- les interfaces électriques ARINC de l'équipement sous test sont adaptées à l'émission/réception des signaux ARINC 429.

## Patentansprüche

1. Prüfstand für elektromagnetische Kompatibilität, bezeichnet als "CEM", umfassend:
• eine sich im Test befindende Ausrüstung, markiert mit "SRT", die dazu bestimmt ist, in ein Luftfahrzeug eingebaut zu werden, wobei die genannte Ausrüstung CEM-Test unterzogen wird und am Eingang und am Ausgang elektrische Schnittstellen vom Typ "Aeronautical Radio, Incorporated", markiert mit "ARINC" ausgibt;
• eine Vorrichtung mit elektrischen Schnittstellen, markiert mit "DIE", die eine Blitzableiter-Ausrüstung darstellt und eine Erfassungs- und / oder Generierungskarte von ARINC-Signalen umfasst und an die ARINC-Eingänge und -Ausgänge der sich im Test befindenden Ausrüstung angeschlossen ist; und
• eine Kontroll- / Steueröffnung, markiert mit "BCC", für die Analyse der Kontrollsignale, die von der Vorrichtung mit elektrischen Schnittstellen stammen, umfassend eine Karte für den Erwerb und / oder die Generierung von ARINC-Signalen;
**dadurch gekennzeichnet, dass** sie ebenfalls umfasst
• ein Umwandlungssystem von Signalen für den Schutz der Kontroll- / Steueröffnung, die geeignet ist, um ein elektrisches ARINC-Signal in ein optisches Signal umzuwandeln und umgekehrt, wobei das genannte Umwandlungssystem von Signalen zwischen der genannten Kontroll- / Steueröffnung und der Vorrichtung mit elektrischer Schnittstelle angeschlossen ist.

2. CEM-Prüfstand gemäß Anspruch 1, **dadurch gekennzeichnet, dass** die Vorrichtung mit elektrischer Schnittstelle umfasst:
• einen Blitzableiter (31), der die Begrenzung der maximalen Spannung von 20 VDC im gemeinsamen Modus zulässt;
• eine für die erste Umwandungsvorrichtung geeignete Eingangsimpedanz.

3. CEM-Prüfstand gemäß irgendeinem der Ansprüche 1 bis 2, **dadurch gekennzeichnet, dass** das Umwandlungssystem von Signalen für den Schutz einer Kontrollöffnung umfasst:
• eine erste Umwandlungsvorrichtung (1) eines elektrischen ARINC-Signals in ein optisches TTL-Signal und / oder umgekehrt;
• eine zweite Umwandlungsvorrichtung (1') eines elektrischen ARINC-Signals in ein optisches TTL-Signal und / oder umgekehrt;
• wenigstens eine Glasfaser, die die Verbringung der optischen Signale vom ersten zum zweiten Wandler und / oder umgekehrt zulässt,
wobei das genannte Umwandlungssystem von Signalen einerseits an die Kontroll- / Steueröffnung und andererseits an die sich im Test befindliche Ausrüstung angeschlossen ist, wobei diese Letztere eine Karte für den Erwerb und / oder das Generieren von ARINC-Signalen umfasst.

4. CEM-Prüfstand gemäß Anspruch 3, **dadurch gekennzeichnet, dass**:
• die Vorrichtung mit elektrischen Schnittstellen die erste Umwandlungsvorrichtung (1) umfasst;
• die Kontroll- / Steueröffnung die zweite Umwandlungsvorrichtung (1') umfasst, und
• die Glasfaser die Vorrichtung mit elektrischen Schnittstellen mit der Kontroll- / Steueröffnung mittels der ersten und zweiten Umwandlungsvorrichtungen (1, 1') anschließt.

5. CEM-Prüfstand gemäß irgendeinem der Ansprüche 3 bis 4, **dadurch gekennzeichnet, dass** elektrische Befehle, die ausgehend von der Kontroll- / Steueröffnung erzeugt werden, durch die zweite Umwandlungsvorrichtung (1') in optische Signale umgewandelt werden und mittels einer Glasfaser (17) in der ersten Umwandlungsvorrichtung (1) ausgegeben werden, die in die elektrischen ARINC-Formate umgewandelten Signale an eine Vorrichtung mit elektrischen Schnittstellen ausgibt.

6. CEM-Prüfstand gemäß irgendeinem der Ansprüche 1 bis 5, **dadurch gekennzeichnet, dass** die sich im Test befindende Ausrüstung ein Regulierungssystem ist.

7. CEM-Prüfstand gemäß irgendeinem der Ansprüche 3 bis 6, **dadurch gekennzeichnet, dass** jede Umwandlungsvorrichtung (1, 1') einen Eingangskonnektor (Jo) umfasst, der geeignet ist, ein erstes ARINC-Signal zu empfangen und in einer ersten Spur (V1) auszugeben, wobei die genannte erste Spur (V1) umfasst:
• einen ersten Wandler (C1) des ersten ARINC-Signals, das in einem ersten elektrischen TTL-Signal empfangen wird;
• einen zweiten Wandler (C2) des ersten elektrischen TTL-Signals, das zuvor in ein erstes optisches TTL-Signal umgewandelt wurde;
• ein Sender-Bauteil (C_{GEN}) des ersten optischen TTL-Signals, das zuvor zu einem optischen Konnektor (J₁) umgewandelt wurde, der an eine Glasfaser (13) angeschlossen ist, die die Verbringung des genannten ersten optischen TTL-Signals zu einer Kontrollausrüstung erlaubt.

8. CEM-Prüfstand gemäß irgendeinem der Ansprüche 3 bis 7, **dadurch gekennzeichnet, dass** jede Umwandlungsvorrichtung (1, 1') einen optischen Wandler (J₁) umfasst, der geeignet ist, um ein zweites optisches TTL-Signal (17) zu empfangen und es in einer zweiten Spur (V2) auszugeben, umfassend:
• ein Erwerbsbauteil (C_{ACQ}) des zweiten optischen TTL-Signals, das aus dem optischen Wandler (J₁) stammt;
• einen dritten Wandler (C3) des zweiten optischen TTL-Signals, das in einem zweiten elektrischen TTL-Signal empfangen wird;
• einen vierten Wandler (C4) des zweiten elektrischen TTL-Signals, das zuvor in ein zweites ARINC-Signal umgewandelt wurde.

9. CEM-Prüfstand gemäß irgendeinem der Ansprüche 7 bis 8, **dadurch gekennzeichnet, dass** sie darüber hinaus eine Versorgung (PSU) umfasst, die eine Versorgung mit Gleichspannung an die erste Spur (V1) und die zweite Spur (V2) ausgibt.

10. CEM-Prüfstand gemäß irgendeinem der Ansprüche 1 bis 9, **dadurch gekennzeichnet, dass**:
• das erste ARINC-Signal und das zweite ARINC-Signal ARINC-Signale 429 sind; und
• die elektrischen ARINC-Schnittstellen der sich im Test befindenden Ausrüstung für die Ausgabe / den Empfang der ARINC-Signale 429 geeignet sind.

## Claims

1. Electromagnetic compatibility test bench, said "EMC", comprising:
• an item of equipment under test, noted "SRT", intended to be loaded on board an aircraft, said item of equipment being subjected to EMC tests and delivering electrical interfaces of type "Aeronautical Radio, Incorporated", noted "ARINC", as inputs and as output;
• an electrical interfaces device, noted "EID", representative of an item of anti-lightning equipment and comprising an ARINC signals acquisition and/or generation card connected to the ARINC inputs and outputs of the item of equipment under test; et
• a command/control rack, noted "CCR", for the analysis of control signals originating from the electrical interfaces device comprising an ARINC signals acquisition and/or generation card;
**characterised in that** it further comprises
• a signals conversion system for protecting the command/control rack adapted to convert an electrical ARINC signal into an optical signal and vice versa, said signals conversion system being connected between said command/control rack and the electrical interface device.

2. EMC test bench according to claim 1, **characterised in that** the electrical interfaces device comprises:
• a lightning protection (31) making it possible to limit the maximum common mode voltage to 20VDC;
• an input impedance suited to the first converter device.

3. EMC test bench according to any of claims 1 to 2, **characterised in that** the signals conversion system for protecting a command/control rack comprises:
• a first device (1) for converting an ARINC electrical signal into a TTL optical signal and/or vice versa;
• a second device (1') for converting an ARINC electrical signal into a TTL optical signal and/or vice versa;
• at least one optical fibre making it possible to route optical signals from the first to the second converter and/or vice versa,
said signals conversion system being on the one hand connected to the command/control rack and on the other hand to the item of equipment under test, the latter comprising an ARINC signals acquisition and/or generation card.

4. EMC test bench according to claim 3, **characterised in that**:
• the electrical interfaces device comprises the first converter device (1);
• the command/control rack comprises the second converter device (1'), and
• the optical fibre connects the electrical interfaces device to the command/control rack through the intermediary of the first and the second converter devices (1, 1').

5. EMC test bench according to any of claims 3 to 4, **characterised in that** electrical commands generated from the command/control rack are converted by the second converter device (1') into optical signals and are delivered by means of an optical fibre (17) to the first converter device (1) delivering to the electrical interfaces device signals converted (14) to ARINC electrical formats.

6. EMC test bench according to any of claims 1 to 5, **characterised in that** the item of equipment under test is a regulation system.

7. EMC test bench according to any of claims 3 to 6, **characterised in that** each converter device (1, 1') comprises an input connector (Jo) capable of receiving a first ARINC signal and delivering it into a first channel (V1), said first channel (V1) comprising:
• a first converter (C1) of the first ARINC signal received into a first TTL electrical signal;
• a second converter (C2) of the previously converted first TTL electrical signal into a first TTL optical signal;
• a component for transmitting (C_{GEN}) the previously converted first TTL optical signal to an optical connector (J1) connected to an optical fibre (13) making it possible to route said first TTL optical signal to a control item of equipment.

8. EMC test bench according to any of claims 3 to 7, **characterised in that** each converter device (1, 1') comprises an optical connector (J1) capable of receiving a second TTL optical signal (17) and delivering it into a second channel (V2) comprising:
• a component for acquiring (C_{ACQ}) the second TTL optical signal originating from the optical connector (J1);
• a third converter (C3) of the second TTL optical signal received into a second TTL electrical signal;
• a fourth converter (C4) of the previously converted second TTL electrical signal into a second ARINC signal.

9. EMC test bench according to any of claims 7 to 8 **characterised in that** it further comprises a supply (PSU) delivering to the first channel (V1) and to the second channel (V2) a direct voltage supply.

10. EMC test bench according to any of claims 1 to 9, **characterised in that**:
- the first signal and the second ARINC signal are ARINC 429 signals and;
- the ARINC electrical interfaces of the item of equipment under test are suited to the transmission/reception of ARINC 429 signals.
